**Europäisches Patentamt**

**European Patent Office**

**Office européen des brevets**

(19)

(11) Veröffentlichungsnummer: **0 071 847**
**B1**

(12)                              **EUROPÄISCHE PATENTSCHRIFT**

(45) Veröffentlichungstag der Patentschrift:
**16.10.85**

(21) Anmeldenummer: **82106686.7**

(22) Anmeldetag: **23.07.82**

(51) Int. Cl.⁴: **G 01 R 33/02**, H 02 P 5/40

(54) **Verfahren und Vorrichtung zum Bestimmen der Läuferzeitkonstante einer feldorientierten Drehfeldmaschine.**

(30) Priorität: **03.08.81 DE 3130692**

(43) Veröffentlichungstag der Anmeldung:
**16.02.83 Patentblatt 83/7**

(45) Bekanntmachung des Hinweises auf die Patenterteilung:
**16.10.85 Patentblatt 85/42**

(84) Benannte Vertragsstaaten:
**AT DE FR GB IT**

(56) Entgegenhaltungen:
**EP - A - 0 043 973**

**Patent Abstract of Japan, Band 5, Nr. 153, 26. September 1981 & JP-A-56-86089**
**Patent Abstracts of Japan, Band 5, Nr. 141, 5 September 1981 & JP-A-56-74092**
**SIEMENS FORSCHUNGS- UND ENTWICKLUNGS-BERICHTE; Band 1, Nr. 1, 1972 F. BLASCHKE "Das Verfahren der Feldorientierung zur Regelung der Asynchronmaschine", Seiten 184-193**

(73) Patentinhaber: **Siemens Aktiengesellschaft, Berlin und München Wittelsbacherplatz 2, D-8000 München 2 (DE)**

(72) Erfinder: **Gabriel, Rupprecht, Dipl.-Ing., Lindenstrasse 84, D-7302 Nellingen-Parksiedlung (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf ein Verfahren zum Bestimmen der Läuferzeitkonstante einer Drehfeldmaschine gemäss dem Oberbegriff des Anspruches 1, sowie auf eine Vorrichtung zur Durchführung des Verfahrens.

Für eine Regelung oder Steuerung einer Drehfeldmaschine ist es vorteilhaft, den Maschinen-Ständerstrom in Abhängigkeit von der jeweiligen Richtung des die Maschine durchsetzenden magnetischen Flusses so zu steuern, dass durch die flussparallele Komponente des Maschinenstroms eine gewünschte (inbesondere konstante) Stärke des Feldes und durch die flusssenkrechte Komponente des Maschinen-Ständerstroms das Drehmoment oder Drehzahl eingestellt wird. Für einen derartigen feldorientierten Betrieb der Drehfeldmaschine ist daher ein Stellglied für den Ständerstrom und eine dem Ständerstrom-Stellglied vorgeschaltete Steuereinrichtung erforderlich, wobei die Steuereinrichtung eine Information über die Richtung des Flusses erhalten muss. Diese Information kann von einer Flussnachbildungsschaltung geliefert werden, die als elektrisches Modell der Drehfeldmaschine aus Betriebsdaten, insbesondere aus den Ständerströmen («Strommodell») und einem eingegebenen Parameter für die Läuferzeitkonstante der Drehfeldmaschine, die Flussrichtung eines nachgebildeten Modellflusses bestimmt. Wird nun je ein Sollwert für die feldbildende (flussparallele) und die drehmomentbildende (flusssenkrechte) Komponente des Maschinenständerstroms vorgegeben (feldorientierte Sollwerte), so kann durch die Steuereinrichtung der Maschinenstrom auf einen aus den beiden Sollwerten entsprechend der Flussrichtung des Modellflusses zusammengesetzten, ständerorientierten Ständerstromvektor geregelt oder gesteuert werden (Siemens Forschungs- und Entwicklungs-Berichte, Bd. 1, Nr. 1, 1972, S 184 bis 193).

Da sich jedoch die vom Läuferwiderstand und Läuferinduktivität bestimmte Läuferzeitkonstante während des Betriebes der Drehfeldmaschine durch Erwärmung und Sättigungseinflüsse verändert, führt eine feste Einstellung der Läuferzeitkonstante in der Flussnachbildungsschaltung zu Abweichungen vom tatsächlichen Maschinenfluss, die zu einer Fehlsteuerung der Maschine führen können.

Der Erfindung liegt die Aufgabe zugrunde, beim Betrieb einer feldorientierten Drehfeldmaschine durch Bestimmen der Läuferzeitkonstante den der Flussermittlungsschaltung einzugebenden Parameterwert jeweils möglichst genau einzustellen.

Dies geschieht bei einem Verfahren der eingangs angegebenen Art und bei einer Vorrichtung zur Durchführung dieses Verfahrens erfindungsgemäss entsprechend den im Kennzeichen des Anspruchs 1 bzw. 4 angegebenen Merkmalen.

Die Erfindung geht davon aus, dass bei einer Fehleinstellung des Parameters fpr die Läuferzeitkonstante die flussbildende und die feldbildende Komponente des Maschinenstroms nicht entkoppelt sind, also eine Änderung des Sollwerts für die feldbildende (flussparallele) Komponente sich in einer Änderung der direkt von der drehmomentbildenden (flusssenkrechten) Komponente beeinflussten Betriebsgrössen der Drehfeldmaschinen auswirkt bzw. umgekehrt eine Änderung des Sollwertes für die drehmomentbildende Komponente eine entsprechende Änderung in Betriebsgrössen hervorruft, die unmittelbar durch die feldbildende Stromkomponente bestimmt sind (z.B. der EMK der Maschine). Wird daher auf den Sollwert der einen Komponente eine Störgrösse mit zeitlich nicht-konstantem Verlauf aufgeschaltet und der zeitliche Verlauf des Istwerts einer von der anderen Komponente bestimmten Betriebsgrösse erfasst, so kann aus der Korrelation zwischen der eingegebenen Störgrösse und dem zeitlichen Verlauf des erfassten Istwerts eine bei Fehleinstellung der Läuferzeitkonstanten auftretende Kopplung bestimmt werden und der für die Steuerung verwendete Läuferzeitkonstanten-Parameter so lange verändert werden, bis diese Korrelation praktisch verschwindet. Ist die Maschine belastet, so wirkt sich ein periodisches, statistisches oder pseudostatistisches Störsignal insbesondere beim Sollwert für die flussparallele Stromkomponente nicht unmittelbar auf das Drehmoment aus und der Betrieb der Drehfeldmaschine wird dadurch nicht merklich gestört. Als von der drehmomentbildenden Komponente abhängiger Istwert eignet sich insbesondere die Läuferbeschleunigung der Drehfeldmaschine oder eine andere, unmittelbar daraus ableitbare Grösse (z.B. die Drehzahl).

Eine vorteilhafte Vorrichtung zur Durchführung des Verfahrens sowie bevorzugte Weiterbildung der Erfindung sind in den Unteransprüchen gekennzeichnet.

Die Erfindung wird anhand eines Ausführungsbeispiels und dreier Figuren näher erläutert.

Fig. 1 zeigt ein Vektordiagramm zur Erläuterung der Erfindung,

Fig. 2 eine Vorrichtung zur Durchführung des Verfahrens und

Fig. 3 einen Störgrössengenerator.

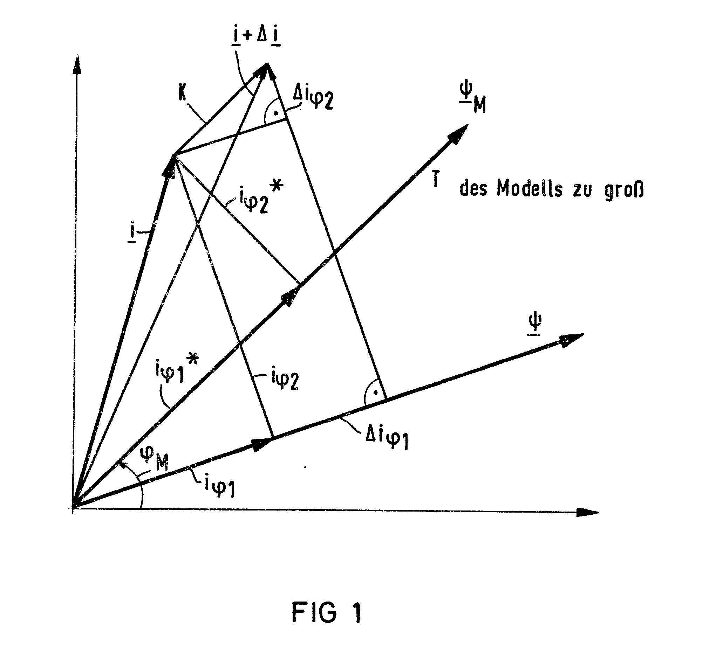

In Fig. 1 ist der durch vektorielle Addition der Phasenströme gebildete, dem Ständerstrom zugeordnete Stromvektor $\underline{i}$ des Ständerstroms sowie der in Richtung der Feldachse weisende Flussvektor $\underline{\psi}$ dargestellt. Die Projektion von $\underline{i}$ auf $\underline{\psi}$ stellt die flussparallele Komponente $i_{\varphi 1}$ dar, zu der der Flussbetrag $\psi$ proportional ist. Das Drehmoment der Maschine ist bei konstant gehaltenem Fluss proportional der dazu senkrechten Komponente $i_{\varphi 2}$ des Ständerstromvektors $\underline{i}$. Wird der Ständerstrom $\underline{i}$ durch Vorgabe von entsprechenden Sollwerten $i^{*}_{\varphi 1}$ und $i^{*}_{\varphi 2}$ eingestellt, die die feldparallele und feldsenkrechte Stromkomponente bezüglich eines Modell-Flussvektors $\psi_M$ darstellen, und wird dieser Modell-Flussvektor unter Verwendung eines willkürlich eingestellten Parameters fpr die Läuferzeitkonstante berechnet, so ergibt sich z.B. für einen zu gross gewählten Parameter die Darstellung nach Fig. 1.

Wird nun beispielsweise auf den Sollwert $i^*_{\varphi1}$ die Störgrösse K aufgeschaltet, ohne dass der Sollwert $i^*_{\varphi2}$ verändert wird, so wird dadurch der Maschinenstrom auf $\underline{i} + \Delta\underline{i}$ erhöht. Weicht nun $\psi_M$ con $\psi$ ab, so ändert sich die tatsächliche feldsenkrechte Komponente $i_{\varphi2}$ trotz des konstant gehaltenen Sollwertes $i^*_{\varphi2}$ um den Betrag $\Delta i\varphi_2$. Diese Änderung macht sich in einer Änderung des Drehmoments bzw. der Drehzahl bemerkbar und kann über diese Grössen erfasst werden. Mit Annäherung des Parameters an die tatsächliche Läuferzeitkonstante wird $\Delta i_{\varphi2}$ geringer und verschwindet schliesslich bei befriedigender Einstellung des Parameters.

Zum Bestimmen der Läuferzeitkonstante wird folglich von dem bekannten feldorientierten Betrieb einer Drehfeldmaschine ausgegangen, bei dem

a) aus Betriebsdaten (d.h. bei Verwendung des «Strommodells» aus den durch den Ständerstromvektor $\underline{i}$ dargestellten Ständerströmen) und einem eingegebenen Parameter T für die Laufzeitkonstante der Drehfeldmaschine ein Modell-Flussvektor oder zumindest die Flussrichtung eines nachgebildeten Modellflusses bestimmt wird,

b) je ein Sollwert $i^*_{\varphi1}$, $i^*\varphi_2$ für die feldbildende (flussparallele) und die drehmomentbildende (flusssenkrechte) komponente des Maschinen-Ständerstroms $\underline{i}$ vorgegeben wird und

c) der Maschinen-Ständerstrom auf einen aus den beiden Sollwerten entsprechend der Flussrichtung des Modellflusses $\psi_M$ zusammengesetzten Ständerstromvektor $\underline{i}$ geregelt oder gesteuert wird.

Die Erfindung sieht nun vor, dass

d) dem Sollwert ($i^*_{\varphi1}$) für die eine Komponente eine Störgrösse K mit zeitlich nicht konstantem Verlauf aufgeschaltet wird,

e) der zeitliche Verlauf des Istwerts einer von der anderen Komponente ($i_{\varphi2}$) bestimmten Betriebsgrösse erfasst wird,

f) eine Korrelationsgrösse für die Korrelation im zeitlichen Verlauf der Störgrösse und der erfassten Betriebsgrösse bestimmt wird und

g) der eingegebene Parameter T für die Läuferzeitkonstante in Abhängigkeit von der Korrelationsgrösse verändert wird, bis die Korrelationsgrösse praktisch Null wird.

Dabei wird vorteilhaft, wie in Fig. 1 dargestellt, die Störgrösse K dem Sollwert $i^*_{\varphi1}$ für die feldbildende Komponente des Ständerstroms aufgeschaltet. Als zu erfassende Betriebsgrösse eignet sich dann insbesondere die Läuferbeschleunigung oder eine daraus ableitbare Grösse (Drehmoment, Drehzahl) der Drehfeldmaschine. Die Störgrösse weist bevorzugt einen periodischen, statistischen oder pseudostatistischen zeitlichen Verlauf auf.

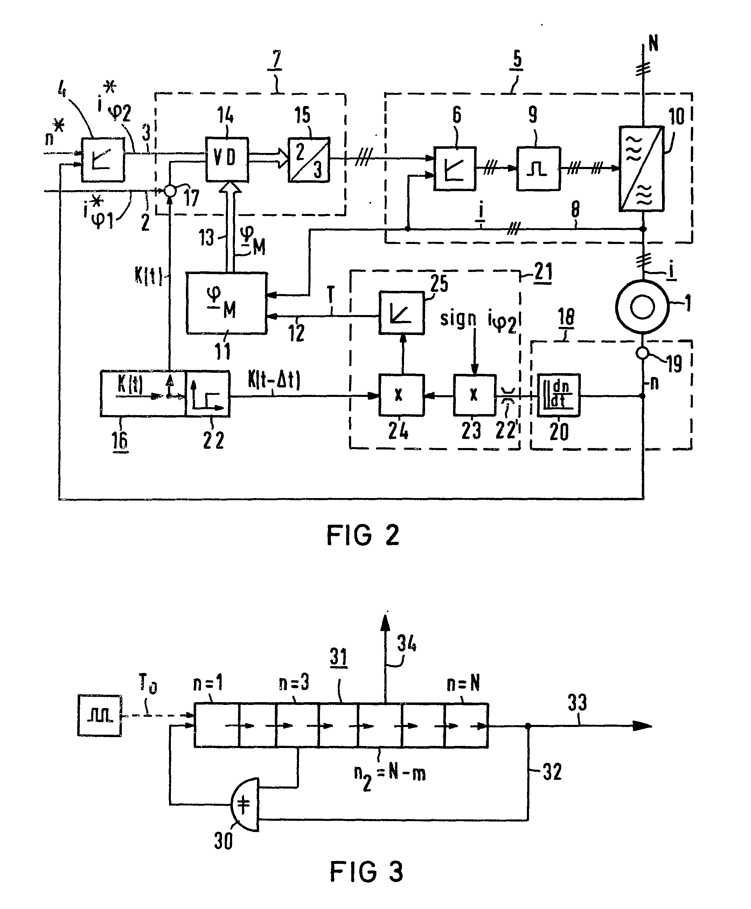

Eine Vorrichtung zur Durchführung des Verfahrens ist in Fig. 2 dargestellt. Als Drehfeldmaschine sei eine Asynchronmaschine 1 betrachtet. Für die Steuerung dieser Asynchronmaschine ist an einem Eingang 2 ein Sollwert $i^*_{\varphi1}$ für die flussbildende Komponente des Ständerstromes vorgegeben, mit der Fluss der Drehfeldmaschine konstant gehalten werden kann. An einem weiteren Eingang 3 ist der Sollwert $i^*_{\varphi2}$ für die flusssenkrechte Ständerstromkomponente vorgegeben, der z.B. von einem überlagerten Drehzahlregler 4 gebildet wird. Ferner ist vorgesehen: Ein Stellglied 5 steuert den Strom der Drehfeldmaschine, indem z.B. für jeden Phasenstrom einer dreiphasigen Drehfeldmaschine ein Regler 6 aus von einer Steuereinrichtung 7 gelieferten Sollwerten und über eine Istwertleitung 8 eingespeisten Istwerten für den Ständerstrom entsprechende Steuerspannungen bildet, die in einem Steuerglied 9 zu entsprechenden Zündimpulsen für einen zwischen einen Wechselstromnetz N und der Drehfeldmaschine angeordneten Umrichter 10 verarbeitet werden.

Eine Flussnachbildungsschaltung 11, die z.B. als «Strommodell» ausgebildet sein kann und von Betriebsdaten der Drehfeldmaschine (in diesem Fall den Ist- oder Sollwerten des Ständerstromes) sowie über einen Eingabeeingang 12 von einem Parameter T für die Läuferzeitkonstante gespeist ist, stellt einen Modellwert für den nachgebildeten Fluss der Drehfeldmaschine bereit. Dieser Fluss kann z.B. als entsprechender Vektor $\psi_M$ durch seinen Betrag $\psi_M$ und einen Winkel $\varphi_M$ berechnet werden, wobei für die Durchführung des Verfahrens lediglich der Winkel $\varphi_M$ benötigt wird, der an der Leitung 13 als in die Richtung des nachgebildeten Flusses weisender Einheitsvektor $\underline{\varphi}_M$ durch seine beiden Komponenten cos $\varphi_M$, sin $\varphi_M$ bezüglich eines ortsfesten Koordinatensystems ausgegeben wird. Ein entsprechendes Strommodell ist z.B. in Fig. 4 der deutschen Patentanmeldung P 30 26 202.3 veröffentlicht am 4.2.1982 (entspricht EP-A- 0043973), dargestellt.

Eine Steuereinrichtung 7, die dem Ständerstrom-Stellglied 5 vorgeschaltet ist, benutzt an den Eingängen 2 und 3 eingegebene Sollwerte für die flussparallele und flusssenkrechte Komponente $i^*_{\varphi1}$, $i^*_{\varphi2}$ des Ständerstromes sowie den Flussrichtungs-Modellwert $\varphi_M$ um die Eingabegrösse für das Ständerstrom-Stellglied 5 zu bilden. Hierzu kann z.B. ein Vektordreher 14 vorgesehen sein, der die feldorientiert vorgegebenen Komponenten des Soll-Ständerstromes in ständerbezogene (ortsfeste) Koordinaten umrechnet, d.h. eine Drehung des Bezugssystems um den an der Leitung 13 eingegebenen Modell-Richtungsvektor $\underline{\varphi}_M$ durchführt. Ein Koordinatenwandler 15 bildet aus den beiden ständerbezogenen kartesischen Komponenten drei Sollwerte, die entsprechend den Richtungen der an die drei Umrichterausgänge angeschlossenen Ständerwicklungen durch vektorielle Addition den Ständerstrom-Sollvektor ergeben.

Ein Generator 16 erzeugt eine Störgrösse K mit zeitlich nicht-konstantem Verlauf, die dem Sollwert für eine der beiden Ständerstromkomponenten überlagert ist. Bevorzugt ist die Störgrösse K einem Additionsglied 17 an der Eingabeleitung 2 für den Sollwert der feldparallelen Ständerstromkomponente $i^*_{\varphi 1}$ aufgeschaltet.

Ein Messgied 18 erfasst den zeitlichen Verlauf einer Betriebsgrösse der Drehfeldmaschine, die bei feldorientiertem Betrieb, d.h. wenn durch richtige Wahl des Parameters T für die Läuferzeitkonstante der Einfluss der beiden feldorientierten Ständerstromsollwerte $i^*_{\varphi 1}$, $i^*_{\varphi 2}$ auf den Fluss und das Drehmoment entkoppelt ist, von dem nicht mit der Störgrösse überlagerten Sollwert bestimmt ist. In dem bevorzugten Fall, dass an der durch das Additionsglied 17 gebildeten Überlagerungsstelle die Störgrösse K dem feldparallelen Sollwert $i^*_{\varphi 1}$ aufgeschaltet ist, erfasst das Messglied 18 eine von dem Drehmoment abhängige Grösse; insbesondere kann das Messglied einen Drehzahlfühler 19 mit nachgeschaltetem Differenzierglied 20 enthalten und stellt somit eine der Drehbeschleunigung bzw. dem Drehmoment proportionale Grösse an seinem Ausgang bereit.

Ein Rechenglied 21, das von dem Ausgang des Messgliedes 18 und der Störgrösse K beaufschalgt ist, bestimmt eine Korrelationsgrösse, die der Korrelation zwischen dem zeitlichen Verlauf der Störgrösse und dem zeitlichen Verlauf der vom Messglied 18 erfassten Betriebsgrösse zugeordnet ist.

Durch Aufschaltung der Korrelationsgrösse auf den entsprechenden Eingabeeingang 12 der Flussnachbildungsschaltung 11 wird der Parameter T in der Flussnachbildungsschaltung 11 solange entsprechend dieser Korrelationsgrösse verstellt, bis von dem Rechenglied praktisch keine Korrelation mehr feststellbar ist.

Wie anhand von Fig. 1 bereits erläutert wurde, wirkt sich bei exakter Feldorientierung ($\psi_M = \psi$) die Störgrössenaufschaltung am Sollwert $i^*_{\varphi 1}$ nicht auf die drehmomentbildende Komponente $i_{\varphi 2}$ aus; jedoch bei einer lediglich vermeintlichen Feldorientierung (Fehleinstellung des Läuferzeitkonstanten-Parameters T, $\psi_M \neq \psi$) tritt nach einer gewissen Verzögerung, die durch die Totzeit des Regelkreises bestimmt ist, eine Veränderung der drehmomentbildenden Stromkomponente um $\Delta i_{\varphi 2}$ auf, die sich in einer entsprechenden Änderung der Drehzahl bzw. der Beschleunigung bemerkbar macht. Wird nun die Störgrösse K mit einer mittleren Frequenz verändert, die klein genug ist, dass nicht allein schon die dynamische Trägheit des Stellgliedes und des Messgliedes diese Schwankungen ausmittelt, so findet sich jede Veränderung von K nach einer gewissen Laufzeit als Veränderung in der Drehzahl bzw. dem Drehmoment wieder.

Zur Berücksichtigung dieser Laufzeit ist dem Störgrösseneingang des Rechengliedes ein Verzögerungsglied 22 vorgeschaltet. Die Laufzeit im Verzögerungsglied 22 ist unkritisch. Lediglich sollte sie grösser sein als die von der Regelstrecke hervorgerufene Phasenverschiebung, aber nicht so gross, dass eine einmalige, zur Zeit t vorgenommene Änderung der Störgrösse K (t) am Eingang 2 nach der Laufzeit $\Delta t$ am Ausgang des Messgliedes 18 bereits in einen stationären Zustand abgeklungen wäre. Die Änderungen der Störgrösse K (t) bzw. der dem Rechenglied 21 aufgeschalteten verzögerten Störgrösse K (t − $\Delta t$) machen sich dann als entsprechende Änderungen des Drehmoments bemerkbar, die dem durch die Sollwerte $i^*_{\varphi 1}$, $i^*_{\varphi 2}$ vorgegebenen Drehmomentverlauf überlagert sind. Wird für K (t) ein zeitlicher Verlauf gewählt, der sich deutlich genug von dem zeitlichen Verlauf der Stromsollwerte unterscheidet, z.B. eine wesentlich höhere Frequenz aufweist, so können die dadurch entstehenden höherfrequenten Überlagerungen eindeutig der mangelnden Entkopplung von Fluss und Drehmoment, d.h. der Fehleinstellung der Laufzeitkonstanten, zugeordnet werden.

Als Störgrösse eignet sich somit ein sinusförmiges Signal oder ein sich periodisch sprunghaft änderndes Signal, vorzugsweise wird jedoch ein statistisches Signal, insbesondere ein binäres Signal mit statistischen oder pseudostatistischen Zustandsänderungen, verwendet. Dann treten entsprechende statistische Änderungen in der erfassten Drehbeschleunigung auf, und die Korrelation mit den statistischen Messwertänderungen an der Sollwerteingabe kann mit grosser Sicherheit festgestellt werden.

Ob eine positive Änderung des Sollwertes für die feldparallele Komponente bei einem zu gross gewählten Parameter T eine positive oder negative Änderung der Beschleunigung bewirkt, hängt ausser von der Drehrichtung auch davon ab, ob motorischer oder generatorischer Betrieb vorliegt. Vorteilhaft ist daher das Ausgangssignal des Messgliedes 18, das an einer Begrenzerschaltung 22 in seinem positiven und negativen Ausschlag begrenzt ist, mittels eines ersten Multiplizierers 23 mit dem Vorzeichen des drehmomentbildenden Stromes $i_{\psi 2}$ multipliziert. Zur Bildung der Korrelationsgrösse wird sodann die Drehbeschleunigung mit der Störgrösse multipliziert (Multiplizierer 24), wobei die Störgrösse eine binäre Spannung entsprechend dem Zustand «Null» oder «Eins» des vor der entsprechenden Verzögerungszeit $\Delta t$ abgegebenen Störgrössensignals K ist. Bei einer zu klein gewählten Läuferzeitkonstanten bewirkt z.B. ein Übergang auf K = 1 eine positive Drehbeschleunigung $\dot{n} = \dfrac{dn}{dt}$, so dass der Ausgang des Multiplizierers 24 eine positive Grösse n(t) · K(t−$\Delta t$) bereitstellt. Beschleunigungsänderungen, die durch Änderungen der Sollwerte $i^*_{\varphi 1}$, $i^*_{\varphi 2}$ hervorgerufen und nicht mit der Störgrösse korreliert sind, mitteln sich gegenseitig weg, so dass der zeitliche Mittelwert $\dot{n}(t) \cdot K(t-\Delta t)$ proportional der Fehleinstellung $\Delta T$ des Parameters T ist und als Korrelationsgrösse verwendet werden kann, um den eingestellten Parameterwert zu korrigieren. Hierzu dient der Integrator 25, der sowohl die Bildung des Mittelwertes $\dot{n}(t) \cdot K(t-\Delta t) = \Delta T$ wie auch im Sinn eines Integralreglers die (proportional zu $\Delta T$ vorzunehmende) Nachführung des eingestellten Parameters am Einstelleingang der Flussermittlungseinrichtung vornimmt. Das Integrator-Ausgangssignal nimmt dann nur noch geringfügig um die tatsächliche Läuferzeitkonstante streuende Werte an.

Ein vorteilhafter Generator zur Erzeugung eines praktisch statistischen Störgrössensignals ist in Fig. 3 dargestellt. Dieser sogenante PRBS-Generator («Pseudo-Random-Binary-Sequence»-Generator) besteht aus einem Schieberegister mit N Speicherplätzen. Im Takt (Impulsabstand $T_0$) eines externen Taktgebers wird der Inhalt jedes Speichers $n = 1, \ldots, N$ an den nächsten Speicher abgegeben, wobei gleichzeitig der Speicherinhalt des letzten Speichers in den ersten Speicher über ein Exklusiv-Oder-Glied 30 rückgeführt wird. Ist der Inhalt der einzelnen Speicher zu Beginn wahllos auf «Null» oder «Eins» gesetzt, so ist dann nach insgesamt N Schiebetakten der Inhalt des ersten Speichers an der Rückführungsleitung 32 bzw. am Ausgang 33 des Schieberegisters angelangt. Da dem Gatter 30 jedoch gleichzeitig mit dem Inhalt des letzten Speichers auch der Inhalt eines anderen Speichers, z.B. des Speichers $n_1 = 3$, zugeführt wird und der Speicherinhalt des ersten Speicherplatzes nur dann zu «Eins» gesetzt wird, wenn bei dem entsprechenden Schiebetakt der Inhalt des dritten und des letzten Speichers gleich ist, wird der Inhalt des ersten Speichers bei jedem Schiebevorgang entsprechend der zufälligen Übereinstimmung oder Nichtübereinstimmung der Speicherplätze $n_1 = 3$ und $N = 7$ willkürlich geändert. Während der N Taktimpulse, die zum Durchlaufen eines Eingabewertes im Schieberegister benötigt werden, gibt das Exklusiv-Oder-Glied 30 Werte ein, die sich praktisch zufällig ändern, so dass jeweils nach N Taktimpulsen nunmehr eine von der ursprünglichen Belegung verschiedene Belegung der Speicherplätze vorliegt und ausgelesen wird. Das dargestellte Schieberegister mit $N = 7$ und $n_1 = 3$ weist erst nach 127 Taktimpulsen wieder die ursprünglich eingegebene Belegung der einzelnen Speicherplätze auf. Durch Vergrösserung der Zahl der Speicherplätze im Schieberegister kann diese Periode ohne grossen Aufwand wesentlich vergrössert werden. Das am Ausgang 33 abgegriffene Binärsignal ist somit praktisch als ein statistisches Signal anzusehen.

Das Verzögerungsglied 22 kann bei diesem PRBS-Generator dadurch verwirklicht werden, dass das verzögerte Störgrössensignal am Speicher N, das unverzögerte Signal aber am Speicherplatz $n_2 = N - m$ (Leitung 34) abgegriffen wird. Das an diesem Ausgang 34 ausgelesene Signal erscheint erst nach m Schiebeimpulsen auch am Ausgang 33. Der Ausgang 33 liefert also das um die Laufzeit $\Delta = m \cdot T_0$ gegenüber dem am Signal 34 anliegenden Störsignal verzögerte Störsignal.

Wird ein Messglied 18 mit digitalem Ausgangssignal verwendet, so kann der Generator 16 mit dem Verzögerungsglied 22 sowie das Rechenglied 21 als ein einziges digitales Schaltungsglied ausgeführt sein. Es ist bereits bekannt, für die Flussnachbildung und die Steuerung einen digitalen Rechner (Mikrocomputer) zu verwenden. In diesen Fällen kann der Mikrocomputer so programmiert werden, dass er auch die einfachen Funtionen des Störgrössengenerators 16 und des Rechengliedes 21 übernimmt. Für die Durchführung des Verfahrens sind dann gegenüber einer digital gesteuerten Drehfeldmaschine keinerleizusätzliche Schaltungsmittel erforderlich.

Das Verfahren stört den feldorientierten Betrieb einer belasteten Drehfeldmaschine nicht. Vielmehr liefert es selbst für kleine Frequenzen (praktisch bis zum Stillstand) den für den feldorientierten Betrieb erforderlichen Wert der Läuferzeitkonstante mit guter Genauigkeit.

**Patentansprüche**

1. Verfahren zum Bestimmen der Läuferzeitkonstante (T) einer Drehfeldmaschine (1), wobei

a) aus Betriebsdaten und einem eingegebenen Parameter (T) für die Läuferzeitkonstante der Drehfeldmaschine die Flussrichtung (Winkel $\varphi_M$) eines nachgebildeten Modellflusses ($\psi_M$) bestimmt wird,

b) je ein Sollwert für die feldbildende (flussparallele) Komponente ($i^*_{\varphi 1}$) und die drehmomentbildende (flusssenkrechte) Komponente ($i^*_{\varphi 2}$) des Maschinenstroms vorgegeben wird, und

c) der Maschinen-Ständerstrom ($\underline{i}$) auf einen aus den beiden Sollwerten entsprechend der Flussrichtung des Modellflusses zusammengesetzten Ständerstrom geregelt oder gesteuert wird, dadurch gekennzeichnet, dass

d) dem Sollwert ($i^*_{\varphi 1}$) für die eine Komponente eine Störgrösse (K) mit zeitlich nicht-konstantem Verlauf aufgeschaltet wird,

e) der zeitliche Verlauf des Istwerts ($\dot{n} = \dfrac{dn}{dt}$) einer von der anderen Komponente ($i_{\varphi 2}$) bestimmten Betriebsgrösse (Drehzahl n) erfasst wird,

f) eine Korrelationsgrösse (Mittelwert von

$$\int K \ (t - \Delta t) \cdot \dot{n} \ (t) \ \cdot \ dt = \Delta T)$$ für die Korrelation

im zeitlichen Verlauf der Störgrösse und der erfassten Betriebsgrösse bestimmt wird, und

g) der eingegebene Parameter (T) für die Läuferzeitkonstante in Abhängigkeit von der Korrelationsgrösse ($\Delta T$) verändert wird, bis die Korrelationsgrösse praktisch Null wird.

2. Verfahren nach Anspruch 1, dadurch gekennzeichnet, dass die Störgrösse dem Sollwert ($i^*_{\varphi 1}$) für die feldbildende Komponente des Ständerstroms aufgeschaltet und als Betriebsgrösse die Beschleunigung ($n = \dfrac{dn}{dt}$) oder eine daraus ableitbare Grösse (Drehzahl) der Drehfeldmaschine bestimmt wird.

3. Verfahren nach Anspruch 1 oder 2, dadurch gekennzeichnet, dass eine Störgrösse mit periodischem, statistischem oder pseudostatistischem zeitlichen Verlauf aufgeschaltet wird.

4. Vorrichtung zur Durchführung des Verfahrens nach einem der Ansprüche 1 bis 3, mit

a) einem Stellglied (5) für den Ständerstrom der Drehfeldmaschine (1),

b) einer von Betriebsdaten (Ständerstrom $\underline{i}$) der Drehfeldmaschine und einem an einem Eingabeeingang (12) eingegebenen Parameter für die Läuferzeitkonstante gespeisten Flussnachbildungsschaltung (11), die einen Modellwert (Winkel $\varphi_M$) für die Richtung eines nachgebildeten Flusses der Drehfeldmaschine bereitstellt,

c) einer dem Ständerstrom-Stellglied (5) vorgeschalteten Steuereinrichtung (9), die aus Sollwerten für die flussparallele und flusssenkrechte Komponente ($i^{\cdot}_{\varphi1}$, $i^{\cdot}_{\varphi2}$) des Ständerstroms und dem Flussrichtungs-Modellwert die Eingabegrösse für das Ständerstrom-Stellglied liefert, gekennzeichnet durch

d) einen Generator (16) zur Erzeugung einer Störgrösse ($K(t)$) mit zeitlich nicht-konstantem Verlauf, die dem Sollwert für eine der beiden Ständerstrom-Komponenten überlagert ist,

e) ein Messglied (18) zur Erfassung des zeitlichen Verlaufs einer Betriebsgrösse (Beschleunigung $\frac{dn}{dt}$) der Drehfeldmaschine, die von der nicht mit der Störgrösse überlagerten Stromkomponente ($i_{\varphi2}$) bestimmt ist,

f) ein von dem Ausgang des Messgliedes (18) und der verzögerten Störgrösse ($K(t-\Delta t)$) beaufschlagtes Rechenglies (21) zur Bestimmung einer Korrelationsgrösse ($\Delta T = \dot{n}(t) \cdot K(t-\Delta t)$) für den zeitlichen Verlauf der Störgrösse und der vom Messglied erfassten Betriebsgrösse,

g) einer Aufschaltung der Korrelationsgrösse (Integrator 25) auf den Parametereingabeeingang (12) der Flussnachbildungsschaltung (11).

5. Vorrichtung nach Anspruch 4, dadruch gekennzeichnet, dass die Störgrösse ($K(t)$) einem Additionsglied (17) an einer Leitung (2) für den Sollwert der feldparallelen Ständerstromkomponente ($i^{\cdot}_{\varphi1}$) aufgeschaltet ist und dass das Messglied (18) einen die Läuferbeschleunigung erfassender Fühler, insbesondere ein Drehzahlfühler mit nachgeschaltetem Differenzierglied (20), enthält.

6. Vorrichtung nach Anspruch 4 oder 5, dadurch gekennzeichnet, dass die Verzögerung ($\Delta t$) der Störgrösse durch ein dem Störgrösseneingang des Rechengliedes (21) vorgeschaltetes Verzögerungsglied (22) erfolgt.

7. Vorrichtung nach einem der Ansprüche 4 bis 6, dadurch gekennzeichnet, dass der Störgrössengenerator (Fig. 3) eine Binärfolge, insbesondere eine periodische statistische oder pseudostatistische Folge binärer Signale, erzeugt.

8. Vorrichtung nach einem der Ansprüche 4 bis 7, dadurch gekennzeichnet, dass das Rechenglied (21) einen Multiplizierer (24) für die Störgrösse und das Ausgangssignal des Messgliedes sowie einen Integrator am Multiplizierer-Ausgang enthält und der Integrator-Ausgang dem Parametereingabeeingang (12) der Flussnachbildungsschaltung (11) aufgeschaltet ist.

9. Vorrichtung nach einem der Ansprüche 4 bis 8, dadurch gekennzeichnet, dass für den Störgrössengenerator (16), das Verzögerungsglied (22) und das Rechenglied (21) und vorzugsweise auch für die Flussnachbildungsschaltung (11) und die Steuereinrichtung (7) ein Mikrocomputer verwendet wird.

**Revendications**

1. Procédé pour déterminer la constante de temps (T) du rotor d'une machine à champ tournant (1), où

a) la direction du flux (angle $\varphi_M$) d'un flux modèle simulé ($\psi_M$) est déterminée à partir de caractéristiques de fonctionnement et d'un paramètre (T) introduit pour la constante de temps du rotor de la machine,

b) une valeur de consigne ($i^{\cdot}_{\varphi1}$) est fixée au préalable pour la composante (parallèle au flux) génératrice de champ et une valeur de consigne ($i^{\cdot}_{\varphi2}$) est fixée au préalable pour la composante (perpendiculaire au flux) génératrice de couple du courant de la machine, et

c) le courant statorique ($\underline{i}$) de la machine est réglé ou commandé à un courant statorique composé des deux valeurs de consigne selon la direction de flux du flux modèle, caractérisé en ce que

d) une grandeur perturbatrice (K) à variation dans le temps non constante est superposée à la valeur de consigne ($i^{\cdot}_{\varphi1}$) pour l'une des composantes,

e) la variation dans le temps de la valeur réelle ($n = \frac{dn}{dt}$) d'une grandeur de fonctionnement (vitesse de rotation n) déterminée par l'autre composante ($i^{\cdot}_{\varphi2}$) est détectée,

f) une grandeur de corrélation (valeur moyenne de $\int K(t-\Delta t) \cdot \dot{n}(t) \cdot dt = \Delta T$) pour la corrélation dans la variation dans le temps de la grandeur perturbatrice et de la grandeur de fonctionnement détectée est déterminée et

g) le paramètre (T) introduit pour la constante de temps du roror est changé en fonction de la grandeur de corrélation ($\Delta T$) jusqu'à ce que la grandeur de corrélation devienne pratiquement nulle.

2. Procédé selon la revendication 1, caractérisé en ce que la grandeur perturbatrice est superposée à la valeur de consigne ($i^{\cdot}_{\varphi2}$) pour la composante génératrice de champ du courant statorique et la grandeur de fonctionnement utilisée est l'accélération ($n = \frac{dn}{dt}$) ou une grandeur (vitesse de rotation) de la machine à champ tournant qui peut en être dérivée.

3. Procédé selon la revendication 1 ou 2, caractérisé en ce que la grandeur perturbatrice superposée présente une variation dans le temps périodique, statistique ou pseudo-statistique.

4. Dispositif pour la mise en œuvre du procédé selon une des revendications 1 à 3, comprenant

a) un organe (5) pour le réglage du courant statorique de la machine à champ tournant (1),

b) un montage simulateur de flux (11), alimenté par des caractéristiques de fonctionnement (courant statorique $\underline{i}$) de la machine et par un paramètre pour la constante de temps du rotor, appliqué à une entrée d'introduction (12), qui présente une valeur modèle (angle $\varphi_M$) pour la direction d'un flux simulé de la machine,

c) un dispositif de commande(9) monté avant l'élément (5) de réglage du courant statorique, qui fournit la grandeur à appliquer à l'entrée de l'organe final de réglage du courant statorique à partir de valeurs de consigne pour les composantes parallèle au flux et perpendiculaire au flux ($i^*_{\varphi1}$, $i^*_{\varphi2}$), caractérisé par

d) un générateur (16) pour produire une grandeur perturbatrice ($K(t)$) à variation dans le temps non constante, qui est superposée à la valeur de consigne pour une des deux composantes du courant statorique,

e) un organe de mesure (18) pour détecter la variation dans le temps d'une grandeur de fonctionnement (accélération $\frac{dn}{dt}$) de la machine, qui est déterminée par la composante de courant ($i^*_{\varphi2}$) à laquelle n'est pas superposée la grandeur perturbatrice,

f) un élément arithmétique (21), sur lequel agit la sortie de l'organe de mesure (18) et la grandeur perturbatrice retardée ($K(t-\Delta t)$) pour déterminer une grandeur de corrélation ($\Delta T = \dot{n}(t) \cdot K(t-\Delta t)$) pour la variation dans le temps de la grandeur perturbatrice et de la grandeur de fonctionnement détectée par l'organe de mesure,

g) une superposition de la grandeur de corrélation (intégrateur 25) à l'entrée d'introduction du paramètre (12) du montage simulateur de flux (11).

5. Dispositif selon la revendication 4, caractérisé en ce que la grandeur perturbatrice ($K(t)$) est superposée à un élément d'addition (17) sur une ligne (2) pour la valeur de consigne de la composante de courant statorique parallèle au champ ($i^*_{\varphi1}$) et que l'organe de mesure (18) contient un capteur détectant l'accélération du rotor, en particulier un capteur de vitesse de rotation suivi d'un élément différentiateur (20).

6. Dispositif selon la revendication 4 ou 5, caractérisé en ce que le retard ($\Delta t$) de la grandeur perturbatrice est produit par un élément de temporisation (22) précédant l'entrée pour la grandeur perturbatrice de l'élément arithmétique (21).

7. Dispositif selon une des revendications 4 à 6, caractérisé en ce que le générateur de grandeur perturbatrice (figure 3) engendre une suite binaire, en particulier une suite périodique statistique ou pseudostatistique de signaux binaires.

8. Dispositif selon une des revendications 4 à 7, caractérisé en ce que l'élément arithméthique (21) contient un multiplicateur (24) pour la grandeur perturbatrice et le signal de sortie de l'organe de mesure, ainsi qu'un intégrateur prévu à la sortie du multiplicateur, la sortie de l'intégrateur étant connectée à l'entrée (12) pour l'introduction du paramètre du montage simulateur de flux (11).

9. Dispositif selon une des revendications 4 à 8, caractérisé en ce qu'un micro-ordinateur est utilisé pour le générateur de grandeur perturbatrice (16), l'élément de temporisation (22) et l'élément arithmétique (21) et de préférence également pour le montage simulateur de flux (11).

**Claims**

1. A method for determining the time constant (T) of the rotor of an induction machine (1), wherein

a) from operating data and an input parameter (T) for the time constant of the rotor of an induction machine the direction of flow (angle $\gamma_M$) of a balanced model flow ($\psi_M$) is determined;

b) a respective theoretical value is given for the field-forming (flow-parallel) component ($i^*_{\gamma1}$) and the torque-forming (flow-transverse) component ($i^*_{\gamma2}$) of the machine current; and

c) the machine stator current ($\underline{i}$) is regulated or controlled in accordance with the flow direction of the two theoretical values of the model flow; characterised in that

d) on the theoretical value ($i^*_{\gamma1}$) for the one component is superimposed an interference magnitude (K) having a non-constant time course;

e) the time course of the actual value ($\dot{n} = \frac{dn}{dt}$) of an operating magnitude (number of revolutions n) determined by the other component ($i^*_{\gamma2}$) is detected; f) a correlation magnitude (average of $\int K(t-\Delta) \cdot \dot{n}(t) \cdot dt = \Delta T$) for the correlation in time of the interference magnitude and the detected operating magnitude is determined; and

g) the input parameter (T) for the time constant of the rotor is changed in dependence upon the correlation magnitude ($\Delta T$) until the correlation magnitude is virtually zero.

2. A method as claimed in Claim 1, characterised in that the interference magnitude is superimposed upon the theoretical value ($i^*_{\gamma1}$) for the field-forming component of the stator current and as an operating magnitude the acceleration ($\dot{n} = \frac{dn}{dt}$) or a magnitude (speed) of the induction machine, which can be derived therefrom, is determined.

3. A method as claimed in Claim or 2, characterised in that an interference magnitude which has a periodic, statistic or pseudo-statistic time course is superimposed.

4. A device for the implementation of the method as claimed in one of Claims 1 to 3, having

a) an adjusting element (5) for the stator current of the induction machine (1);

b) a flow balancing circuit (11) fed by operating data (stator current $\underline{i}$) of the induction machine and a parameter for the time constant of the rotor, input at an insertion input (12), which circuit makes available a model value (angle $\gamma_M$) for the direction of a balanced flow of the induction machine;

c) a control device (9) which precedes the adjusting element (5) of the stator current and supplies the input magnitude for the adjusting element of the stator current from the theoretical values for the flow-parallel and flow-transverse components ($i^*_{\gamma 1}$, $i^*_{\gamma 2}$) of the stator current and the model value of the direction of flow; characterised by

d) a generator (16) for generating an interference magnitude ($K(t)$) which has a non-constant course in time and is superimposed upon the theoretical value for one of the two stator current components;

e) a measuring element (18) for detecting the time course of an operating magnitude (acceleration $\frac{dn}{dt}$) of the induction machine determined by the current component ($i_{\gamma 2}$) which is not superimposed by the interference magnitude;

f) a calculating element (21) controlled by the output of the measuring element (18) and the delayed interference magnitude ($K(t-\Delta t)$) which serves to determine a correlation magnitude ($\Delta T = \dot{n}(t) \cdot K(t-\Delta t)$) for the time course of the interference magnitude and the operating magnitude determined by the measuring element; and

g) a connection of the correlation magnitude (intergrator 25) to the parameter insertion input (12) of the flow balancing circuit (11).

5. A device as claimed in Claim 4, characterised in that the interference magnitude ($K(t)$) is superimposed upon an adding element (17) on a line (2) for the theoretical value of the field-parallel stator current component ($i^*_{\gamma 1}$) and that the measuring element (18) contains a sensor, in particular a speed sensor with a following differentiating element (20), which detects the rotor acceleration.

6. A device as claimed in Claim 4 or 5, characterised in that the delay ($\Delta t$) of the interference magnitude is effected by a delay element (22) which precedes the input of the interference element of the calculating element (22).

7. A device as claimed in one of Claim 4 to 6, characterised in that the interference magnitude generator (Fig. 3) generates a binary sequence, in particular a periodic, statistic or pseudostatistic sequence of binary signals.

8. A device as claimed in one of Claims 4 to 7, characterised in that the calculating element (21) comprises a multiplier (24) for the interference magnitude and the output signal of the measuring element as well as an integrator at the multiplier output, and the integrator output is superimposed upon the parameter insertion input (12) of the flow balancing circuit (11).

9. A device as claimed in one of Claims 4 to 8, characterised in that a micro-computer is used for the interference magnitude generator (16), the delay element (22) and the calculating element (21) and preferably also for the flow balancing circuit (11) and the control device (7).

1/2

FIG 1

FIG 2

FIG 3